## Europäisches Patentamt
## European Patent Office
## Office européen des brevets

(11) Numéro de publication: **0 068 946**
**B1**

(12) ## FASCICULE DE BREVET EUROPEEN

(45) Date de publication du fascicule du brevet:
27.03.85

(51) Int. Cl.⁴: **H 01 L 25/08**, H 01 L 25/04, **H 03 B 7/14**

(21) Numéro de dépôt: **82401039.1**

(22) Date de dépôt: **08.06.82**

(54) Procédé de réalisation d'un composant unitaire comportant une diode oscillatrice et une diode à capacité variable, et émetteur accordable en fréquence comprenant un tel composant unitaire.

(30) Priorité: **19.06.81 FR 8112145**

(43) Date de publication de la demande:
**05.01.83 Bulletin 83/1**

(45) Mention de la délivrance du brevet:
**27.03.85 Bulletin 85/13**

(84) Etats contractants désignés:
**DE GB NL**

(56) Documents cités:
**EP - A - 0 005 096**
**FR - A - 2 133 494**
**FR - A - 2 231 109**

**IEEE TRANSACTIONS ON MICROWAVE THEORY AND TECHNIQUES, vol.MTT-27, no.5, mai 1979, New York (US) T.A. MIDFORD et al.: "Millimeter-wave CW IMPATT diodes and oscillators", pages 483-492**

(73) Titulaire: **THOMSON-CSF, 173, Boulevard Haussmann, F-75379 Paris Cedex 08 (FR)**

(72) Inventeur: **Heitzmann, Michel, THOMSON-CSF SCPI 173, bld Haussmann, F-75379 Paris Cedex 08 (FR)**

(74) Mandataire: **Lepercque, Jean et al, THOMSON-CSF SCPI 173, Bld Haussmann, F-75379 Paris Cedex 08 (FR)**

BUNDESDRUCKEREI BERLIN

# Description

L'invention concerne un procédé de réalisation d'un composant unitaire, comportant une diode oscillatrice et une diode à capacité variable, les deux diodes étant du type à l'état solide. L'invention concerne également un émetteur à ondes millimétriques accordable en fréquence comprenant un tel composant unitaire.

On connait par la demande de brevet EP-A-0 005 096 au nom de la Demanderesse (brevet US 4 280 110), une réalisation de source d'ondes millimétriques, accordable en fréquence, du type comportant un premier composant unitaire constitué par une première diode capable de fonctionner en oscillatrice, un disque de diélectrique solide entourant cette diode, une première électrode jouant le rôle de support, et une métallisation jouant le rôle d'électrode de polarisation, la source comportant en outre un deuxième composant unitaire constitué de manière analogue par une deuxième diode, celle-ci étant capable de fonctionner en diode à capacité variable. Un émetteur accordable en fréquence est réalisable à l'aide de deux composants unitaires placés tête-bêche dans un tronçon de guide d'ondes, de telle sorte que les électrodes de polarisation soient très proches l'une de l'autre. Les polarisations convenables sont assurées par des moyens distincts mis en place dans le tronçon de guide d'ondes.

Ce système présente l'inconvénient d'utiliser deux composants unitaires distincts, ce qui complique la mise en place dans le tronçon die guide d'ondes:

a) d'une part, au point de vue géométrique et mécanique, en raison de la nécessité de fournir deux moyens de fixation, dont l'un est réglable pour ajuster le couplage des deux composants;

b) d'autre part, au point de vue de l'agencement des deux polarisations distinctes sur deux électrodes très rapprochées.

L'invention tend à remédier à ces inconvénients.

Le procédé selon l'invention, pour la réalisation d'un composant unitaire comportant une première diode semiconductrice capable d'osciller ondes millimétriques, et une deuxième diode semiconductrice de type à capacité variable, est caractérisé en ce qu'il comporte au moins les étapes suivantes, au cours desquelles:

A) On monte l'une des diodes, en soudant son anode (ou sa cathode) sur une première embase métallique jouant le rôle de radiateur thermique et de première électrode du composant unitaire, en constituant ainsi un premier sous-ensemble;

B) On monte l'autre diode, en soudant son anode (ou sa cathode) sur une deuxième embase métallique jouant le rôle d'une deuxième électrode du composant unitaire, en constituant ainsi un deuxième sous-ensemble;

C) On équipe chaque sous-ensemble d'un anneau diélectrique soudé à l'embase par une première face plane, l'anneau entourant chaque diode de manière à présenter une deuxième face plane dont le plan idéal forme, avec la surface de l'embase délimitée par l'anneau et avec les parois internes de l'anneau, un cylindre contenant entièrement chaque diode;

D) On soude des connexions souples reliant la cathode (ou l'anode) demeurée libre de chaque diode à la deuxième face plane de chaque anneau;

E) On soude les deux sous-ensembles, tête-bêche, par leurs faces planes soudées aux connexions souples, à une troisième électrode du composant unitaire constituée par un disque métallique.

L'invention sera mieux comprise, et d'autres caractéristiques apparaîtront, au moyen de la description qui suit, et des dessins qui l'accompagnent, parmi lesquels:

— la figure 1 représente, en coupe schématique, un exemple de composant unitaire réalisé par le procédé de l'invention;

— la figure 2 représente, en coupe schématique, une partie d'un émetteur à ondes millimétriques utilisant le composant de la figure 1;

— les figures 3 à 5 représentent diverses parties du composant à divers stades de la fabrication;

— la figure 6 représente une variante de l'émetteur.

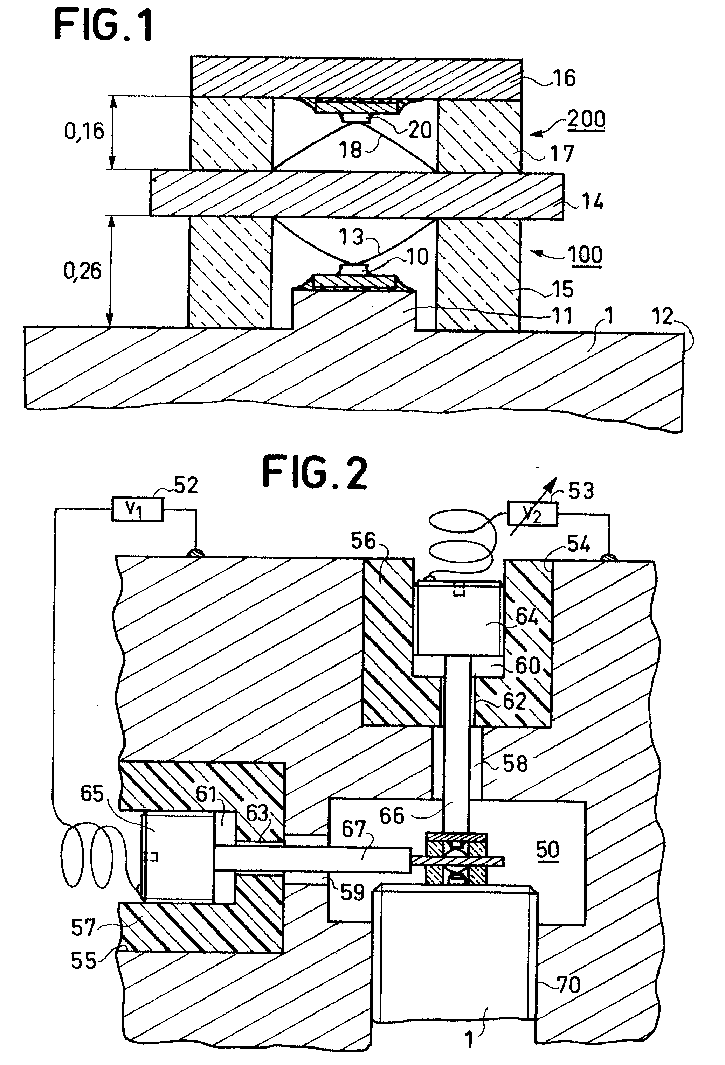

La coupe de la figure 1, représente schématiquement une portion de la première embase métallique 1, sur laquelle on a soudé, au cours de l'étape (A), une diode 10 qui est par exemple la diode destinée à constituer l'élément à résistance négative d'un circuit oscillant, c'est-à-dire une diode semiconductrice soit de type Gunn, soit à avalanche. L'embase 1 possède un picot central 11 et présente un contour cylindrique 12, éventuellement fileté.

La diode 10 est soudée au picot 11 par une face et à une connexion souple 13 par l'autre face. Cette connexion 13 est pincée et soudée entre un disque métallique 14 et un anneau 15 constitué par exemple par un tronçon de tube en verre de type »quartz« (silice fondue). Sur la face du disque 14 opposée à celle qui est soudée sur l'anneau 15, on trouve un deuxième sous-ensemble 200 soudé à l'envers sur le disque 14, lui-même soudé sur le premier sous-ensemble constitué par l'embase 1, l'anneau 15 et la connexion souple 13.

Le deuxième sous-ensemble 200 comprend une embase métallique 16, constituée par un simple disque métallique sans picot central supportant en son centre la deuxième diode 20, laquelle, dans l'exemple choisi plus haut, est du type à capacité variable. Cette diode est entourée par un anneau 17 analogue à l'anneau 15, mais de hauteur moindre en raison de l'absence de picot central. Une connexion souple 18, analogue à la connexion 13, est soudée à la face libre de la diode 20, et pincée entre l'anneau 17 et le disque 14.

Les différentes étapes du procédé de fabrication sont détaillées ci-après:

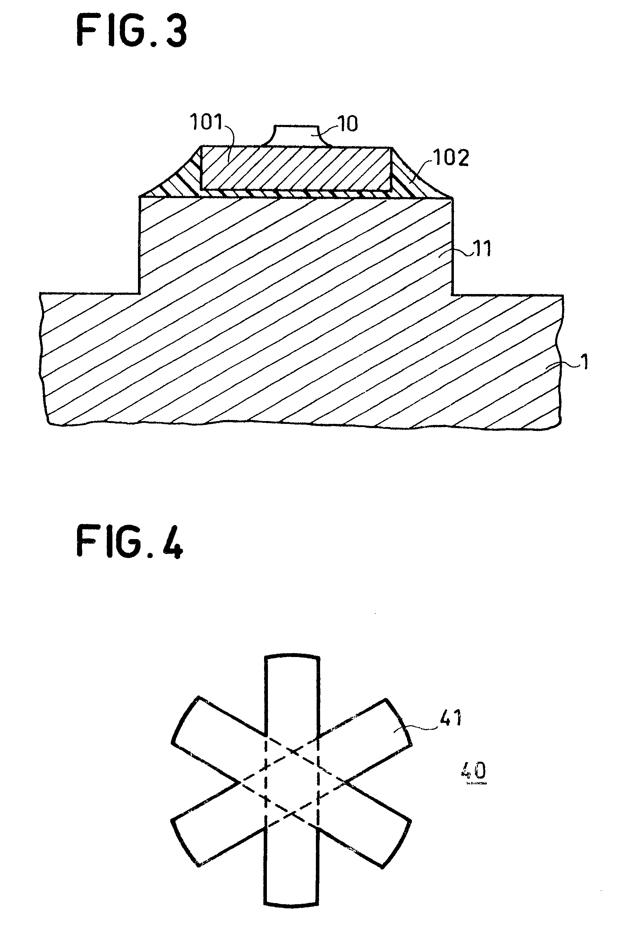

Dans une étape préliminaire, on soude collectivement une plaquette de silicium dans laquelle ont été formée des diodes 10, sur une feuille d'or de 50 μm d'épaisseur. On obtient ensuite par attaque mésa et découpage des »puces nues« c'est-à-dire des radiateurs 101 de dimensions latérales 200 μm sur 200 μm portant chacun une diode mésa 10 (voir figure 3).

L'étape (A) comporte l'opération de soudure du radiateur 101 sur le picot central 11 de l'embase 1 après interposition préalable par exemple d'une préforme de brasure 102 de 25 μm d'épaisseur en alliage orgermanium. Cette préforme, après soudure, est écrasée selon le dessin (Fig. 1 et Fig. 3).

L'étape (B) comporte des opérations identiques à celles de l'étape (A) en ce qui concerne la diode et l'embase. Toutefois il n'est pas nécessaire de munir la diode 20 d'un radiateur thermique si elle est du type à capacité variable, l'énergie de haute fréquence mise en oeuvre dans le matériau semiconducteur étant alors relativement très faible.

Les opération de l'étape (C) consistent simplement à coller ou à souder par exemple par brasure à l'or-étain, les anneaux 15 et 17 sur leurs embase respectives 1 et 16. Ces anneaux ont par exemple les dimensions suivantes:

Diamètre intérieur: 0,40 à 0,45 mm
Diamètre extérieur: 0,75 à 0,80 mm

Hauteur: 0,16 ou 0,26 mm suivant qu'il s'agit de l'anneau 17 ou de l'anneau 15, en raison de la présence du picot 11 de hauteur 0,1 mm dans le cas de l'anneau 15.

Les connexions souples 13 et 18 nécessaires pour l'étape (D) sont fabriquées de la manière suivante.

On découpe par photolithographie suivie d'une attaque chimique, une étoile 40 (figure 4) ayant par exemple six branches 41. L'étoile est en cuivre sous une épaisseur de 100 μm, revêtue d'une couche d'or électrolytique. Le diamètre de l'étoile est du même ordre que le diamètre extérieur des anneaux 15 et 17 avec une marge tenant compte de la différence de niveau des faces à relier.

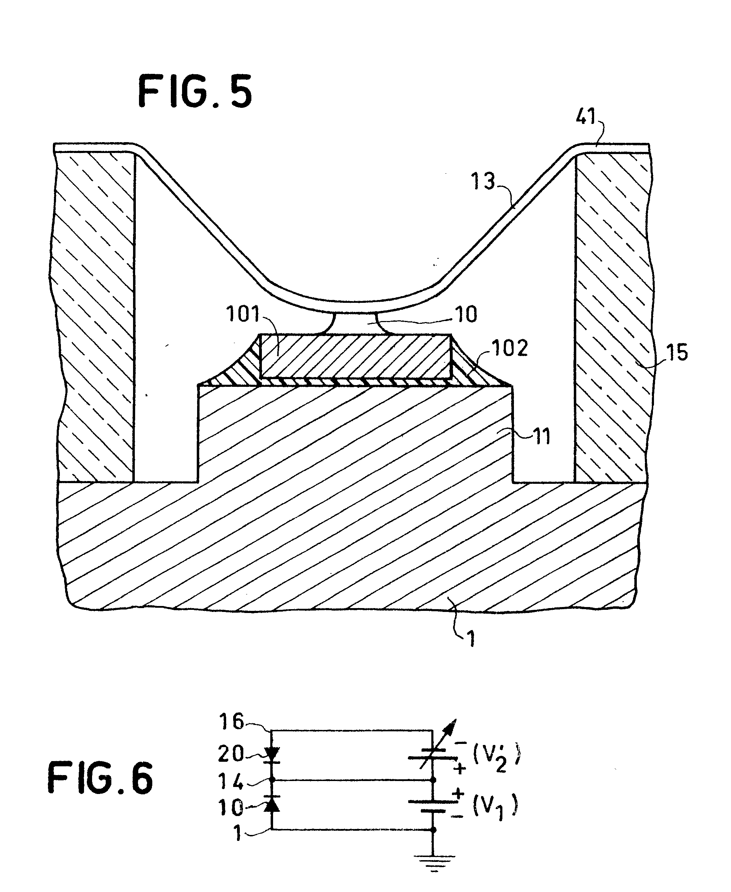

Ainsi qu'il est représenté à la figure 5, le centre de l'étoile 40 est alors soudé à l'électrode de la face libre de la diode 10 (ou 20) et les branches 41 sont appliquées sur la tranche de l'anneau 15 (ou 17) puis soudées par thermocompression.

A l'étape (E), on soude par exemple, par brasure, les deux sous-ensembles, tête-bêche, par les faces planes soudées aux connexions 13 et 18 à un disque métallique, par exemple en cuivre de haute qualité, dont le diamètre est choisi de manière à favoriser la fréquence d'accord recherchée pour la diode 10. Ce diamètre est de l'ordre du millimètre.

Dans la représentation de la figure 2, on a figuré schématiquement la coupe d'une cavité 50 faisant partie d'un guide d'ondes 51 dont on a montré partiellement la section plane perpendiculaire à l'axe longitudinal du guide. Ce guide constitue, avec des sources d'alimentation et/ou de polarisation 52 et 53, des éléments constitutifs d'un émetteur à ondes millimétriques.

Les parois du guide 51, dont l'épaisseur est renforcée à cet effet, au niveau de la cavité 50, comportent une première ouverture 70, débouchant sur un grand côté de la cavité. Dans cette ouverture on fait coulisser l'embase 1 de manière à placer le composant unitaire, soudé sur cette embase, au centre de la cavité. En outre, les parois du guide comportent des chambres cylindriques 54 et 55 prolongées par des ouvertures de plus petit diamètre 58 et 59 jusqu'à la cavité 50. Ces chambres sont remplies par des pièces isolantes 56 et 57 en résine chargée par un matériau absorbant les ondes électromagnétiques de très haute fréquence. Chaque pièce comporte elle-même une chambre 60 (ou 61) prolongée par une lumière 62 (ou 63) jusqu'à l'ouverture 58 (ou 59). Ces chambres servent au déplacement de pistons (64, 65) en métal conducteur de l'électricité prolongées par des tiges conductrices 66 et 67 pouvant être mises au contact des disques 14 et 16 respectivement afin de les polariser. Si $V_1$ et $V_2$ sont respectivement les tensions continues de polarisation, par rapport à la masse, fournies par les sources 52 et 53, les polarisations seront respectivement de $V_1$ pour la diode 10 et de $(V_2-V_1)$ pour la diode 20.

Dans une variante de l'émetteur accordable, représentée à la figure 6, la diode 10 est polarisée en inverse (diode avalanche) par une première source $V_1$ et la diode 20 est polarisée (en inverse) par une deuxième source $V'_2$ connectée entre le pôle de la source $V_1$ distinct de la masse et le disque 16 du composant unitaire relié à la diode 20.

L'avantage de cette variante provient du fait que la tension appliquée à la diode 10, et par conséquent la puissance émise, est alors rendue indépendant du réglage de la deuxième source.

L'invention s'applique notamment aux émetteurs de la bande 94—96 GHz. A titre d'exemple, on a pu obtenir une puissance de l'ordre de 100 mW et une plage d'accord de 96 à 96,4 MHz.

## Revendications

1. Procédé de réalisation d'un composant unitaire comportant une première diode semiconductrice (10) capable d'osciller en ondes millimétriques et une deuxième diode semiconductrice (20) du type à capacité variable, comprenant au moins les étapes suivantes, au cours desquelles:

A) On monte l'une des diodes (1), en soudant son anode (ou sa cathode) sur une première embase métallique (1) jouant le rôle de radiateur thermique et de première électrode du composant unitaire, en constituant ainsi un premier sous-ensemble (100);

B) On monte l'autre diode (20), en soudant son anode (ou sa cathode) sur une deuxième embase métallique (16) jouant le rôle d'une deuxième électrode du composant unitaire, en constituant ainsi un deuxième sous-ensemble (200);

C) On équipe chaque sous-ensemble d'un anneau diélectrique (15, 17) soudé à l'embase par une première face plane, l'anneau entourant chaque diode (10, 20) de manière à présenter une deuxième face plane dont la plan idéal forme, avec la surface de l'embase (1, 16) délimitée par l'anneau (15, 17) et avec les parois internes de l'anneau (15, 17) un cylindre contenant entièrement chaque diode (10, 20);

D) On soude des connexions souple (13, 18) reliant la cathode (ou l'anode) demeurée libre de chaque diode (10, 20) à la deuxième face plane de chaque anneau (15, 17);

E) On soude les deux sous-ensembles, tête-bêche, par leurs faces planes soudées aux connexions souples (13, 18), à une troisième électrode du composant unitaire constituée par un disque métallique (14).

2. Procédé selon la revendication 1, caractérisé en ce qu'il comporte une étape préliminaire au cours de laquelle on dépose collectivement sur l'une des électrodes de la première diode (10, 20) une couche métallique (101) destinée à jouer le rôle de radiateur thermique.

3. Procédé selon la revendication 1, caractérisé en ce qu'à l'étape (A) et à l'étape (B) on interpose préalablement, entre l'embase métallique (1, 16) et la diode, une préforme de brasure (102).

4. Procédé selon la revendication 1, caractérisé en ce qu'à l'étape (C), les anneaux (15, 17) sont constitués par des tronçons de tube en silice fondue.

5. Procédé selon la revendication 1, caractérisé en ce qu'à l'étape (D) on utilise des connexions souples (13, 18) en forme d'étoile (40) à six branches (41).

6. Procédé selon la revendication 1, caractérisé en ce qu'à l'étape (E) on détermine le diamètre du disque métallique (14) constituant la troisième électrode du composant unitaire de manière à favoriser l'oscillation de la première diode sur une fréquence prédéterminée.

7. Emetteur accordable en fréquence, comportant un composant unitaire fabriqué par un procédé selon l'une quelconque des revendications 1 à 6, caractérisé en ce qu'il comporte une cavité (50) munie de trois ouvertures (70, 58, 59) par lesquelles on introduit respectivement le composant unitaire actionné par l'embase métallique (1) du sous-ensemble (100) contenant la première diode (10), une première tige de polarisation (67) placée en contact avec le disque métallique (14) constituant la troisième électrode du composant unitaire, et une deuxième tige de polarisation (66) placée en contact du disque métallique (16) constituant l'embase du sous-ensemble (200) contenant la deuxième diode.

8. Emetteur selon la revendication 7, caractérisé en ce que l'embase (1) du sous-ensemble (100) contenant la première diode est à la masse constituée par les parois de la cavité (50), et que les tiges (66, 67) de polarisation sont isolées de la masse par des pièces (56, 57) en matériau absorbant les ondes électromagnétiques.

**Patentansprüche**

1. Verfahren zur Herstellung eines Bausteins mit einer ersten Halbleiterdiode (10), die im Millimeterwellenbereich schwingen kann, und mit einer zweiten Halbleiterdiode (20) vom Varaktortyp, wobei das Verfahren mindestens die folgenden Schritte umfaßt, in deren Verlauf

A) eine der Dioden (10) montiert wird, indem ihre Anode (oder Kathode) auf eine erste Metallplatte (1) geschweißt wird, die als Wärmeabstrahler und als erste Elektrode des Bauteils wirkt, woraus sich eine erste Baugruppe (100) ergibt;

B) die andere Diode (20) montiert wird, indem ihre Anode (oder Kathode) auf eine zweite Metallplatte (16) geschweißt wird, die als zweite Elektrode des Bausteins wirkt, woraus sich eine zweite Baugruppe (200) ergibt;

C) jede Baugruppe mit einem dielektrischen Ring (15, 17) versehen wird, der mit einer ersten ebenen Seite auf die Platte geschweißt wird und jede Diode (10, 20) so umgibt, daß eine zweite ebene Seite des Rings eine Ebene bildet, die mit der durch den Ring (15, 17) begrenzten Oberfläche der Platte (1, 16) und den Innenwänden des Rings (15, 17) einen Zylinder begrenzt, in dem jede Diode (10, 20) vollständig enthalten ist;

D) biegsame Anschlüsse (13, 18) an die noch freiliegende Kathode (oder Anode) jeder Diode (10, 20) angeschweißt werden, die an die zweite ebene Seite jedes Rings (15, 17) führen;

E) die beiden Baugruppen stirnseitig gegeneinander mit ihren an die biegsamen Anschlüsse (13, 18) angeschweißten ebenen Seiten an eine dritte von einer Metallscheibe (14) gebildeten Elektrode des Bausteins angeschweißt werden.

2. Verfahren nach Anspruch 1, dadurch gekennzeichnet, daß es einen Vorbereitungsschritt umfaßt, während dem kollektiv auf eine der Elektroden der ersten Diode (10, 20) eine Metallschicht (101) aufgebracht wird, die als Wärmeabstrahler wirken soll.

3. Verfahren nach Anspruch 1, dadurch gekennzeichnet, daß beim Schritt (A) und beim Schritt (B) vorab zwischen die Metallplatte (1, 16) und die Diode ein Formling aus Lötmaterial (102) eingefügt wird.

4. Verfahren nach Anspruch 1, dadurch gekennzeichnet, daß beim Schritt (C) die Ringe (15, 17) von Rohrstücken aus geschmolzenem Siliziumdioxid bestehen.

5. Verfahren nach Anspruch 1, dadurch gekennzeichnet, daß beim Schritt (D) biegsame Anschlüsse (13, 18) in Form eines Sterns (40) mit sechs Zacken (41) verwendet werden.

6. Verfahren nach Anspruch 1, dadurch gekennzeichnet, daß beim Schritt (E) der Durchmesser der Metallscheibe (14), die die dritte Elektrode des Bauteils bildet, so bestimmt wird, daß die Schwingung der ersten Diode auf einer vorgegebenen Frequenz bevorzugt wird.

7. In der Frequenz abstimmbarer Sender, der ein nach einem Verfahren gemäß einem beliebigen der Ansprüche 1 bis 6 hergestelltes Bauteil enthält, dadurch gekennzeichnet, daß er eine Kavität (50) mit drei Öffnungen (70, 78, 79) enthält, wobei durch eine dieser Öffnungen das durch die Metallplatte (1) der Baugruppe (100) mit der ersten Diode (10) betätigte Bauteil eingefügt wird, durch die zweite Öffnung ein erster Stab (67) zur Vorspannung, der mit der die dritte Elektrode des Bauteils bildenden Metallscheibe (14) in Kontakt gebracht ist, und durch die dritte Öffnung ein zweiter Stab (66) zur Vorspannung eingeführt wird, der in Kontakt mit der die Baugruppe (200) mit der zweiten Diode bildenden Metallscheibe (16) gebracht ist.

8. Sender nach Anspruch 7, dadurch gekennzeichnet, daß die Basisplatte (1) der Baugruppe (100) mit der ersten Diode auf Masse liegt, die von den Wänden der Kavität (50) gebildet wird, und daß die Stäbe (66, 67) für die Vorspannung von Masse durch Stücke (56, 57) aus einem die elektromagnetischen Wellen absorbierenden Material isoliert sind.

**Claims**

1. A method of fabrication of a module comprising a first semiconductor diode (10) which is capable of oscillating in the millimeter wave range and a second semiconductor diode (20) of the varactor type, wherein said method comprises at least the following steps during which:

(A) one of the diodes (10) is mounted by welding its anode (or cathode) to a first metallic base (1) which performs the function of thermal radiator and of first electrode of the module, thus constituting a first subassembly (100),

(B) the other diode (20) is mounted by welding its anode (or its cathode) to a second metallic base (16) which performs the function of a seconde electrode of the module, thus constituting a second subassembly (200);

(C) each subassembly is equipped with a dielectric ring (15, 17) having a first flat face welded to the base, said ring surrounding each diode (10, 20) so as to provide a second flat face whose ideal plane forms, together with the base surface (1, 16) delimited by the ring (15, 17) and with the internal walls of said ring, a cylinder which entirely contains each diode (10, 20);

(C) flexible connections (13, 18) are welded so as to connect the cathode (or anode) which has remained free in each diode to the second flat face of each ring (15, 17);

(E) the two subassemblies are then welded in top-to-tail relation with their flat faces welded to the flexible connections (13, 18) to a third electrode of the module, said electrode being formed by a metallic disk (14).

2. A method according to claim 1, characterized in that it includes a preliminary step during which a metallic layer (101) having the design function of thermal radiator is deposited collectively on one of the electrodes of the first diode (10, 20).

3. A method according to claim 1, characterized in that, both in step (A) and in step (B), a brazing preform (102) is interposed beforehand between the metallic base (1, 16) and the diode.

4. A method according to claim 1, characterized in that, in step (C), the rings (15, 17) are formed by tube sections of fused silica.

5. A method according to claim 1, characterized in that, in step (D), flexible connections (13, 18) are utilized in the form of six arm (41) star connectors (40).

6. A method according to claim 1, characterized in that, in step (E), the diameter of the metallic disk (14) constituting the third electrode of the module is determined with a view to readily obtaining oscillation of the first diode at a predetermined frequency.

7. A tunable transmitter incorporating a module fabricated by a method according to any one of claims 1 to 6, characterized in that it comprises a cavity (50) provided with three openings (70, 58, 59) through which are introduced respectively the module actuated by the metallic base (1) of the subassembly (100) containing the first diode (10), a first biasing rod (67) placed in contact with the metallic disk (14) which constituted the third electrode of the module, and a second biasing rod (66) placed in contact with the metallic disk (16) which constitutes the base of the subassembly (200) containing the second diode.

8. A transmitter according to claim 7, characterized in that the base (1) of the subassembly (100) containing the first diode is connected to the ground formed by the walls of the cavity (50) and that the biasing rods (66, 67) are isolated from ground by members (56, 57) of material which absorbs the electromagnetic waves.

# FIG.1

# FIG.2

# FIG.3

# FIG.4

# FIG.5

# FIG.6